# FASCICULE DE BREVET EUROPEEN

(11) **EP 2 483 214 B1**
(45) Date de publication et mention de la délivrance du brevet: **19.11.2014**
(21) Numéro de dépôt: 10776775.8
(22) Date de dépôt: 30.09.2010
(51) Int. Cl.: C03C 17/00, C03C 17/245, C23C 14/58

(54) **PROCEDE DE DEPOT DE COUCHE MINCE ET PRODUIT COMPORTANT UNE COUCHE MINCE**
DÜNNSCHICHTABLAGERUNGSVERFAHREN UND DÜNNSCHICHT ENTHALTENDES PRODUKT
THIN FILM DEPOSITION METHOD AND PRODUCT COMPRISING A THIN FILM

(30) Priorité: 01.10.2009 FR 0956866
(43) Date de publication de la demande: 08.08.2012
(73) Titulaire: Saint-Gobain Glass France, 92400 Courbevoie (FR)
(72) Inventeur: KHARCHENKO, Andriy, F-91120 Palaiseau (FR); DURANDEAU, Anne, F-75009 Paris (FR); NADAUD, Nicolas, F-75013 Paris (FR)
(74) Mandataire: Teyssedre, Laurent
(86) Numéro de dépôt international: PCT/FR2010/052073
(87) Numéro de publication internationale: WO 2011/039488

(56) Documents cités:
- WO-A1-2009/157064
- FR-A2- 2 412 508
- GB-A- 1 228 786
- US-A1- 2007 196 695

## Description

L'invention se rapporte au domaine des couches minces inorganiques, notamment déposées sur des substrats.

Les couches minces déposées sur des substrats sont souvent à base de métaux, d'oxydes ou encore de nitrures.

Un procédé couramment employé à l'échelle industrielle pour le dépôt de couches minces, notamment sur substrat verrier, est le procédé de pulvérisation cathodique, notamment assisté par champ magnétique, appelé dans ce cas procédé « magnétron ». Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée. Ce procédé est dit « réactif » lorsque la couche est constituée d'un matériau résultant d'une réaction chimique entre les éléments arrachés de la cible et le gaz contenu dans le plasma. L'avantage majeur de ce procédé réside dans la possibilité de déposer sur une même ligne un empilement très complexe de couches en faisant successivement défiler le substrat sous différentes cibles, ce généralement dans un seul et même dispositif.

Il est par exemple connu de déposer des couches d'oxyde de titane à l'aide d'une cible en titane métallique dans un plasma contenant de l'oxygène.

L'oxygène contenu dans le plasma présente toutefois l'inconvénient d'oxyder superficiellement la cible métallique, si bien que la vitesse de dépôt par pulvérisation cathodique s'en trouve fortement réduite. D'une manière générale, il a été observé que la vitesse de dépôt de couches d'oxyde par pulvérisation cathodique était bien plus faible que la vitesse de dépôt de métaux ou même de nitrures ou de carbures.

La demande FR 2 412 508 décrit le dépôt par vaporisation sous vide d'une couche de titane, suivi d'une oxydation effectuée en chauffant le substrat à une température d'au moins 550°C. La demande US2007/0196695 décrit le dépôt par pulvérisation cathodique d'une couche métallique, notamment en titane, suivi par l'oxydation de cette dernière à une température d'au moins 400°C.

Un but de l'invention est d'obtenir par pulvérisation cathodique des couches d'oxyde métallique avec des vitesses de dépôt élevées.

A cet effet, l'invention a pour objet un procédé d'obtention d'un substrat revêtu sur au moins une partie de sa surface d'au moins une couche d'oxyde d'un métal M dont l'épaisseur physique est inférieure ou égale à 30 nm, ladite couche d'oxyde n'étant pas comprise dans un empilement de couches comprenant au moins une couche d'argent, ledit procédé comprenant les étapes suivantes :
- on dépose par pulvérisation cathodique au moins une couche intermédiaire d'un matériau choisi parmi le métal M, un nitrure du métal M, un carbure du métal M ou un oxyde sous-stoechiométrique en oxygène du métal M, ladite couche intermédiaire n'étant pas déposée au-dessus ou en-dessous d'une couche à base d'oxyde de titane, l'épaisseur physique de ladite couche intermédiaire étant inférieure ou égale à 30 nm,
- on oxyde au moins une partie de la surface de ladite couche intermédiaire à l'aide d'un traitement thermique, pendant lequel ladite couche intermédiaire est en contact direct avec une atmosphère oxydante, notamment avec de l'air, la température dudit substrat pendant ledit traitement thermique ne dépassant pas 150°C.

Selon l'invention, l'oxyde est donc obtenu en deux étapes : d'abord une étape de dépôt du métal, du nitrure ou du carbure correspondant, suivie d'une étape d'oxydation à l'aide d'un traitement thermique. Contre toute attente, le réchauffement localisé de la couche intermédiaire, alors qu'elle est en contact avec une atmosphère oxydante, en particulier de l'air, s'est révélé capable d'oxyder des couches minces d'épaisseur relativement importante. Généralement, au moins 80% de l'épaisseur de la couche intermédiaire est oxydée, voire la totalité de la couche dans certains cas.

L'atmosphère oxydante est de préférence de l'air, notamment à la pression atmosphérique. Si besoin, la teneur en oxygène de l'atmosphère peut être augmentée afin de favoriser encore l'oxydation de la couche intermédiaire.

Le traitement thermique a en outre la particularité, contrairement aux traitements de recuit ou de trempe, de ne pas chauffer le verre de manière significative. Il n'est ainsi pas nécessaire de procéder à un refroidissement lent et contrôlé du substrat avant la découpe ou le stockage du verre. Ce procédé rend également possible l'intégration d'un dispositif de chauffage sur les lignes de production continue existantes, plus particulièrement dans l'espace situé entre la sortie de l'enceinte de dépôt sous vide de la ligne magnétron et le dispositif de stockage du verre par empilage. Il est également possible dans certains cas de réaliser le traitement selon l'invention au sein même de l'enceinte de dépôt sous vide.

Le substrat est de préférence une feuille de verre, de vitrocéramique, ou d'une matière organique polymérique. Il est de préférence transparent, incolore (il s'agit alors d'un verre clair ou extra-clair) ou coloré, par exemple en bleu, vert, gris ou bronze. Le verre est de préférence de type silico-sodo-calcique, mais il peut également être en verre de type borosilicate ou alumino-borosilicate. Les matières organiques polymériques préférées sont le polycarbonate ou le polyméthacrylate de méthyle ou encore le polyéthylènetérephtalate (PET). Le substrat présente avantageusement au moins une dimension supérieure ou égale à 1 m, voire 2 m et même 3 m. L'épaisseur du substrat varie généralement entre 0,5 mm et 19 mm, de préférence entre 0,7 et 9 mm, notamment entre 2 et 8 mm, voire entre 4 et 6 mm. Le substrat peut être plan ou bombé, voire flexible.

Le substrat de verre est de préférence du type flotté, c'est-à-dire susceptible d'avoir été obtenu par un procédé consistant à déverser le verre fondu sur un bain d'étain en fusion (bain « float »). Dans ce cas, la couche à traiter peut aussi bien être déposée sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre. Le substrat de verre peut également être obtenu par laminage entre deux rouleaux, technique permettant en particulier d'imprimer des motifs à la surface du verre.

Le métal M est de préférence choisi parmi le titane, l'étain, le zirconium, le zinc, le tungstène, le tantale, le niobium, le molybdène, le chrome, le nickel, le silicium ou l'aluminium. Ces métaux, ou le cas échéant leurs nitrures ou carbures, présentent une absorption importante dans le domaine du proche infrarouge, si bien que des couches constituées de tels métaux sont capables de s'échauffer très rapidement en cas de traitement par rayonnement laser ou à l'aide d'une flamme, techniques qui seront décrites plus en détail dans la suite du texte. Le métal M peut également être un alliage, notamment un alliage binaire de métaux précédemment cités, par exemple un alliage d'étain et de zinc ou un alliage de nickel et de chrome.

Selon un mode de réalisation préféré, la couche intermédiaire est en titane, la couche d'oxyde obtenue après traitement thermique étant alors une couche d'oxyde de titane photocatalytique. Ce procédé est particulièrement intéressant, car à l'heure actuelle les couches photocatalytiques d'oxyde de titane sont obtenues par une étape de dépôt d'oxyde de titane par pulvérisation cathodique, donc à des vitesses de dépôt particulièrement lentes, suivie d'une étape de traitement thermique destinée à cristalliser l'oxyde de titane pour le rendre photocatalytique. Dans le cas du procédé selon l'invention, une couche de titane métallique est déposée, avec des vitesses de dépôt très élevées, et le traitement thermique permet en une seule étape d'oxyder le titane en oxyde de titane et d'obtenir une couche photocatalytique, donc cristallisée au moins en partie. La couche d'oxyde de titane est de préférence au moins partiellement cristallisée sous la forme anatase, la phase rutile pouvant optionnellement être également présente. De telles couches photocatalytiques peuvent également être obtenues par oxydation d'une couche de nitrure de titane, de carbure de titane ou d'oxyde sous-stoechiométrique en oxygène du titane. Ce dernier sera noté TiOₓ. La valeur de x est de préférence inférieure ou égale à 1,8, de sorte que l'absorption de la couche intermédiaire par le rayonnement laser soit suffisante.

L'oxyde de zirconium peut par exemple être obtenu par oxydation d'une couche intermédiaire en zirconium métallique ou en nitrure de zirconium. L'oxyde de zinc peut notamment être obtenu par oxydation d'une couche intermédiaire en zinc métallique.

Le métal M peut être pur ou dopé par d'autres atomes. A titre d'exemple, il est possible de doper le titane par des métaux de transition (par exemple W, Mo, V, Nb), des ions lanthanides ou des métaux nobles (tels que par exemple platine, palladium), ou encore par des atomes d'azote ou de carbone. Une fois le titane oxydé en oxyde de titane, ces différentes formes de dopage permettent soit d'augmenter l'activité photocatalytique du matériau, soit de décaler le gap de l'oxyde de titane vers des longueurs d'onde proches du domaine du visible ou comprises dans ce domaine. De même, le silicium peut être dopé par de l'aluminium, car l'aluminium est fréquemment ajouté aux cibles de silicium afin de les rendre plus conductrices et donc de faciliter le dépôt par pulvérisation cathodique.

L'épaisseur physique de la ou chaque couche d'oxyde du métal M est de préférence inférieure ou égale à 20 nm, notamment 15 nm, voire 10 nm. Pour ce faire l'épaisseur physique de la couche intermédiaire est de préférence inférieure ou égale à 20 nm, voire 15 nm ou même 10 nm. L'épaisseur de la couche intermédiaire est toutefois de préférence supérieure ou égale à 2 nm, voire 3 ou 4 nm. Pour des épaisseurs très faibles en effet, l'absorption du rayonnement infrarouge devient trop faible pour qu'un échauffement suffisamment intense et rapide puisse se produire au niveau de la couche.

La couche intermédiaire peut être traitée sur toute sa surface, de sorte qu'à l'issue du procédé toute la surface du substrat est revêtue d'une couche d'oxyde.

Alternativement, une partie seulement de la surface de la couche intermédiaire peut être traitée thermiquement, notamment dans le but de réaliser des motifs, à finalité esthétique ou fonctionnelle. Comme explicité plus en détail dans la suite du texte, l'utilisation d'un laser ponctuel associé à un système de déplacement dans le plan du substrat est particulièrement adaptée à ce mode de réalisation.

L'invention a donc également pour objet un substrat revêtu sur une partie de sa surface d'une couche d'oxyde d'un métal M dont l'épaisseur physique est inférieure ou égale à 30 nm, et sur une autre partie de sa surface d'une couche d'un matériau choisi parmi ledit métal M, un nitrure dudit métal M ou un carbure dudit métal M. La couche d'oxyde n'est pas comprise dans un empilement de couches comprenant au moins une couche d'argent. Les zones oxydées peuvent représenter par exemple entre 0,1 et 99,9% de la surface du substrat, ou entre 10 et 90% de la surface du substrat. Les zones oxydées et non-oxydées sont bien entendu situées sur la même face du substrat. Les zones oxydées peuvent former tous types de dessins ou de motifs choisis soit pour des raisons esthétiques (dessin, logo...), soit pour des raisons fonctionnelles.

Les couches métalliques ou de nitrure sont absorbantes ou réfléchissantes dans le domaine du visible, tandis que les couches d'oxyde sont transparentes. Le traitement d'oxydation, lorsqu'il ne concerne que certaines zones, permet donc de créer des zones transparentes et des zones absorbantes, selon un dessin prédéfini. Par exemple, des couches miroirs en chrome ou en alliage de nickel et de chrome peuvent être traitées localement de manière à créer des motifs transparents.

De même, les couches métalliques sont conductrices de l'électricité, tandis que les couches d'oxyde sont isolantes. Le traitement selon l'invention peut donc permettre de créer des zones conductrices, donc des électrodes, selon un schéma prédéfini, par exemple en forme de bandes ou encore de grilles. On peut ainsi créer des circuits imprimés transparents, par exemple en oxydant localement des couches conductrices en aluminium ou des couches semi-conductrices en silicium.

De préférence, la température du substrat pendant le traitement thermique ne dépasse pas 100°C, notamment 50°C. Il s'agit notamment de la température au niveau de la face opposée à la face sur laquelle est déposée la couche intermédiaire. Cette température peut être mesurée par exemple par pyrométrie.

Pour ce faire, le traitement thermique d'oxydation est réalisé par une technique propre à chauffer la couche intermédiaire très rapidement, de sorte que le substrat ne s'échauffe pas de manière substantielle.

En particulier, le traitement thermique est de préférence réalisé à l'aide d'au moins un rayonnement laser ou à l'aide d'au moins une flamme (traitement dit de flammage).

Ces techniques ont l'avantage de présenter un coefficient d'échange thermique très élevé, typiquement supérieur à 400 W/(m².s). La puissance surfacique du rayonnement laser au niveau de la couche intermédiaire est même de préférence supérieure ou égale à 20 ou 30 kW/cm². Cette très forte densité d'énergie permet d'atteindre au niveau de la couche intermédiaire la température souhaitée extrêmement rapidement (en général en un temps inférieur ou égal à 1 seconde) et par conséquent de limiter d'autant la durée du traitement, la chaleur générée n'ayant alors pas le temps de diffuser au sein du substrat.

Ainsi, chaque point traité de la couche intermédiaire est de préférence soumis au traitement d'oxydation pour une durée généralement inférieure ou égale à 1 seconde, voire 0,5 seconde. A l'inverse, les lampes infrarouge classiquement utilisées pour des traitements de recuit ne permettent pas d'atteindre ces fortes puissances par unité de surface : le temps de traitement doit être plus long pour atteindre les températures désirées (souvent plusieurs secondes), et le substrat est alors nécessairement porté à des températures élevées par diffusion de la chaleur, ce même si la longueur d'ondes du rayonnement est adaptée pour n'être absorbée que par la couche mince et non par le substrat.

Grâce au très fort coefficient d'échange thermique associé au procédé selon l'invention, même la partie du verre située à 0,5 mm de la couche intermédiaire ne subit généralement pas de températures supérieures à 100°C.

Le procédé est généralement continu : on crée un mouvement relatif entre le substrat revêtu de la couche intermédiaire et les moyens de chauffage (par exemple rayon laser ou dispositif de flammage) de manière à traiter la surface voulue, en général la totalité de la surface.

Le rayonnement laser possède de préférence une longueur d'onde comprise entre 500 et 2000 nm, notamment entre 530 et 1200 nm. C'est en effet dans cette gamme de longueurs d'onde que l'absorption des métaux, nitrures ou carbures est maximale. Ainsi le rayonnement est-il absorbé spécifiquement par la couche intermédiaire et peu par le substrat sous-jacent, ce qui permet de chauffer rapidement la couche intermédiaire sans chauffer le substrat.

De préférence, l'absorption de la couche intermédiaire à la longueur d'onde du rayonnement laser est supérieure ou égale à 20%, notamment 30%. A titre d'exemple, l'absorption par une couche de 10 nm de titane ou de zirconium atteint 40% pour une longueur d'onde de 808 nm. Au contraire, le verre, surtout le verre clair ou extra-clair, absorbe très peu dans cette gamme de longueurs d'onde si bien que le rayonnement ne contribue à chauffer que la couche. L'absorption est définie comme étant égale à la valeur de 100% auxquelles sont soustraites la transmission et la réflexion de la couche.

On utilise de préférence des diodes laser, émettant par exemple à une longueur d'onde de l'ordre de 808 nm, 880 nm, 940 nm, ou encore 980 nm ou 1032 nm. Sous forme de systèmes de diodes, de très fortes puissances peuvent être obtenues, permettant d'atteindre des puissances surfaciques au niveau de la couche à traiter supérieures à 20kW/cm², voire à 30kW/cm².

Pour une simplicité de mise en oeuvre accrue, les lasers employés dans le cadre de l'invention peuvent être fibrés, ce qui signifie que le rayonnement laser est injecté dans une fibre optique puis délivré près de la surface à traiter par une tête de focalisation. Le laser peut également être à fibre, au sens où le milieu d'amplification est lui-même une fibre optique.

Le faisceau laser peut être ponctuel, auquel cas il est nécessaire de prévoir un système de déplacement du faisceau laser dans le plan du substrat. Ce mode de réalisation est particulièrement préféré lorsqu'il s'agit de ne traiter thermiquement qu'une partie de la surface de la couche intermédiaire afin de réaliser des motifs à finalité esthétique ou fonctionnelle. Le faisceau laser ponctuel peut être déplacé dans un plan XY et créer toutes sortes de motifs ou de dessins en transformant des zones absorbantes et/ou réfléchissantes et/ou électro-conductrices en zones transparentes et/ou isolantes électriquement.

Le rayonnement laser est de préférence issu d'au moins un faisceau laser formant une ligne (appelée « ligne laser » dans la suite du texte) qui irradie simultanément toute ou partie de la largeur du substrat. Ce mode est préféré dans le cas où l'on veut traiter toute la surface du substrat, car il évite l'utilisation de systèmes de déplacement coûteux, généralement encombrants, et d'entretien délicat. Le faisceau laser en ligne peut notamment être obtenu à l'aide de systèmes de diodes laser de forte puissance associées à une optique de focalisation. L'épaisseur de la ligne est de préférence comprise entre 0,01 et 1 mm. La longueur de la ligne est typiquement comprise entre 5 mm et 1 m. Le profil de la ligne peut notamment être une courbe de Gauss ou un créneau.

La ligne laser irradiant simultanément toute ou partie de la largeur du substrat peut être composée d'une seule ligne (irradiant alors toute la largeur du substrat), ou de plusieurs lignes, éventuellement disjointes. Lorsque plusieurs lignes sont utilisées, il est préférable qu'elles soient disposées de sorte que toute la surface de l'empilement soit traitée. La ou chaque ligne est de préférence disposée perpendiculairement à la direction de défilement du substrat, ou disposée de manière oblique. Les différentes lignes peuvent traiter le substrat simultanément, ou de manière décalée dans le temps. L'important est que toute la surface à traiter le soit.

Afin de traiter toute la surface de la couche, on met de préférence en oeuvre un déplacement relatif entre d'une part le substrat revêtu de la couche et la ou chaque ligne laser. Le substrat peut ainsi être mis en déplacement, notamment en défilement en translation en regard de la ligne laser fixe, généralement en dessous, mais éventuellement au-dessus de la ligne laser. Ce mode de réalisation est particulièrement appréciable pour un traitement en continu. Alternativement, le substrat peut être fixe et le laser peut être mobile. De préférence, la différence entre les vitesses respectives du substrat et du laser est supérieure ou égale à 1 mètre par minute, voire 4 et même 6, 8, 10 ou 15 mètres par minute, ce afin d'assurer une grande vitesse de traitement.

Lorsque le substrat est en déplacement, notamment en translation, il peut être mis en mouvement à l'aide de tous moyens mécaniques de convoyage, par exemple à l'aide de bandes, de rouleaux, de plateaux en translation. Le système de convoyage permet de contrôler et réguler la vitesse du déplacement. Si le substrat est en matière organique polymérique souple, le déplacement peut être réalisé à l'aide d'un système d'avance de films sous forme d'une succession de rouleaux.

Le laser peut également être mis en mouvement de manière à ajuster sa distance au substrat, ce qui peut être utile en particulier lorsque le substrat est bombé, mais pas seulement. En effet, il est préférable que le faisceau laser soit focalisé sur le revêtement à traiter de sorte que ce dernier soit situé à une distance inférieure ou égale à 1 mm du plan focal. Si le système de déplacement du substrat ou du laser n'est pas suffisamment précis quant à la distance entre le substrat et le plan focal, il convient de préférence de pouvoir ajuster la distance entre le laser et le substrat. Cet ajustement peut être automatique, notamment régulé grâce à une mesure de la distance en amont du traitement.

Lorsque la ligne laser est en déplacement, il faut prévoir un système de déplacement du laser, situé au-dessus ou en dessous du substrat. La durée du traitement est régulée par la vitesse de déplacement de la ligne laser.

Toutes les positions relatives du substrat et du laser sont bien entendu possibles, du moment que la surface du substrat peut être convenablement irradiée. Le substrat sera le plus généralement disposé de manière horizontale, mais il peut aussi être disposé verticalement, ou selon toute inclinaison possible. Lorsque le substrat est disposé horizontalement, le laser est généralement disposé de manière à irradier la face supérieure du substrat. Le laser peut également irradier la face inférieure du substrat. Dans ce cas, il faut que le système de support du substrat, éventuellement le système de convoyage du substrat lorsque ce dernier est en mouvement, laisse passer le rayonnement dans la zone à irradier. C'est le cas par exemple lorsque l'on utilise des rouleaux de convoyage : les rouleaux étant disjoints, il est possible de disposer le laser dans une zone située entre deux rouleaux successifs.

Lorsque les deux faces du substrat sont à traiter, il est possible d'employer plusieurs lasers situés de part et d'autre du substrat, que ce dernier soit en position horizontale, verticale, ou selon toute inclinaison.

Le laser, notamment en ligne, peut être intégré dans une ligne de dépôt de couches, par exemple une ligne de dépôt par pulvérisation cathodique assistée par champ magnétique (procédé magnétron). La ligne comprend en général des dispositifs de manutention des substrats, une installation de dépôt, des dispositifs de contrôle optique, des dispositifs d'empilage. Les substrats défilent, par exemple sur des rouleaux convoyeurs, successivement devant chaque dispositif ou chaque installation.

Le laser est de préférence situé juste après l'installation de dépôt de la couche, par exemple à la sortie de l'installation de dépôt. Le substrat revêtu peut ainsi être traité en ligne après le dépôt de la couche, à la sortie de l'installation de dépôt et avant les dispositifs de contrôle optique, ou après les dispositifs de contrôle optique et avant les dispositifs d'empilage des substrats.

Le laser peut aussi être intégré à l'installation de dépôt. Par exemple, le laser peut être introduit dans une des chambres d'une installation de dépôt par pulvérisation cathodique. Le laser peut aussi être disposé en dehors de l'installation de dépôt, mais de manière à traiter un substrat situé à l'intérieur de ladite installation. Il suffit de prévoir à cet effet un hublot transparent à la longueur d'ondes du rayonnement utilisé, au travers duquel le rayon laser viendrait traiter la couche. Il est ainsi possible de traiter une couche avant le dépôt subséquent d'une autre couche dans la même installation. Afin de ne pas empêcher l'oxydation de la couche intermédiaire, il est possible de traiter l'empilement dans une chambre spéciale, dans laquelle on contrôle l'atmosphère oxydante.

Que le laser soit en dehors de ou intégré à l'installation de dépôt, ces procédés « en ligne » sont préférables à un procédé en reprise dans lequel il serait nécessaire d'empiler les substrats de verre entre l'étape de dépôt et le traitement thermique.

Les procédés en reprise peuvent toutefois avoir un intérêt dans les cas où la mise en oeuvre du traitement thermique selon l'invention est faite dans un lieu différent de celui où est réalisé le dépôt, par exemple dans un lieu où est réalisée la transformation du verre. Le dispositif de rayonnement peut donc être intégré à d'autres lignes que la ligne de dépôt de couches. Il peut par exemple être intégré à une ligne de fabrication de vitrages multiples (doubles ou triples vitrages notamment), ou à une ligne de fabrication de vitrages feuilletés. Dans ces différents cas, le traitement thermique selon l'invention est de préférence réalisé avant la réalisation du vitrage multiple ou feuilleté.

Le laser peut être remplacé par tout dispositif émettant un rayonnement infrarouge et focalisé sur le substrat, par exemple à l'aide de miroirs ou de lentilles, de manière à obtenir une puissance surfacique suffisante.

Le traitement de flammage est de préférence réalisé par au moins un dispositif de flammage situé perpendiculairement au sens de défilement du substrat, ou selon toute direction plus ou moins oblique. Plusieurs dispositifs élémentaires peuvent être associés pour former un seul dispositif. La longueur totale du dispositif de flammage est de préférence au moins égale à la largeur du substrat revêtu, ce qui permet aisément le traitement au défilé sans nécessiter de système de déplacement.

On utilise en général au moins un brûleur. Le ou chaque brûleur peut être à combustion externe, au sens où le mélange entre le combustible et le comburant est réalisé au nez du brûleur ou dans le prolongement de ce dernier. Dans ce cas, le substrat est soumis à l'action d'une flamme. Le brûleur peut également être à combustion interne, au sens où le combustible et le comburant sont mélangés à l'intérieur du brûleur : le substrat est alors soumis à l'action de gaz chauds. Tous les cas intermédiaires sont bien entendu possibles, au sens où une partie seulement de la combustion peut intervenir à l'intérieur du brûleur, et l'autre partie à l'extérieur. Certains brûleurs, en particulier les brûleurs aérauliques, c'est-à-dire utilisant l'air comme comburant, possèdent des chambres de pré-mélange dans lesquelles a lieu tout ou partie de la combustion. Dans ce cas, le substrat peut être soumis à l'action d'une flamme et/ou de gaz chauds. Les brûleurs à oxycombustion, c'est-à-dire utilisant de l'oxygène pur, ne contiennent généralement pas de chambre de pré-mélange. Les gaz chauds peuvent également être produits à l'aide d'une torche plasma : le chauffage n'est pas réalisé par une réaction de combustion, mais par ionisation entre les électrodes de la torche.

Le gaz utilisé peut être un mélange d'un gaz oxydant, notamment choisi parmi l'air, l'oxygène ou leurs mélanges, et d'un gaz combustible, notamment choisi parmi le gaz naturel, le propane, le butane, voire l'acétylène ou l'hydrogène, ou leurs mélanges. L'oxygène est préféré comme gaz oxydant, en particulier en combinaison avec le gaz naturel (méthane) ou le propane, d'une part car il permet d'atteindre des températures plus élevées et par conséquent de raccourcir le traitement et d'éviter la chauffe du substrat, et d'autre part car il permet d'éviter la création d'oxydes d'azote NOx.

Pour atteindre les températures souhaitées au niveau de la couche intermédiaire, le substrat revêtu est généralement positionné au sein de la flamme visible, notamment au niveau de la zone la plus chaude de la flamme, une partie de la flamme visible s'étendant alors autour de la zone traitée.

La température des gaz chauds est de préférence comprise entre 1300 et 2200°C, notamment entre 1300 et 1700°C dans le cas de brûleurs aérauliques. La vitesse des gaz chauds est de préférence comprise entre 5 et 100 mètres par seconde.

La couche d'oxyde obtenue selon l'invention peut être la seule couche déposée sur le substrat, ou appartenir à un empilement de couches. Dans ce dernier cas, elle peut notamment être la dernière couche de l'empilement.

Lorsque la couche d'oxyde est une couche d'oxyde de titane photocatalytique, cette dernière est normalement la dernière couche de l'empilement déposé sur le substrat, autrement dit la couche de l'empilement la plus éloignée du substrat. Il importe en effet que la couche photocatalytique soit en contact avec l'atmosphère et ses polluants. Il est toutefois possible de déposer sur la couche photocatalytique une très fine couche, généralement discontinue ou poreuse. Il peut par exemple s'agir d'une couche à base de métaux nobles destinée à accroître l'activité photocatalytique du matériau. Il peut encore s'agir de fines couches hydrophiles, par exemple en silice, tel qu'enseigné dans les demandes WO 2005/040058 ou WO 2007/045805. Une sous-couche destinée à empêcher la migration des ions alcalins du substrat vers la couche d'oxyde de titane peut être disposée entre le substrat et la couche photocatalytique. A titre d'exemple, il peut notamment s'agir d'une couche à base d'oxyde, nitrure, oxynitrure, ou encore oxycarbure de silicium ou d'aluminium, ou encore à base d'oxyde de zirconium ou d'étain. Toutefois, le traitement thermique selon l'invention étant de courte durée et ne portant pas le verre à des températures élevées, la migration des alcalins est très réduite, si bien que la couche barrière à la migration des alcalins n'est pas indispensable. Une sous-couche peut toutefois être utile dans le cas où le substrat aurait à subir un traitement thermique ultérieur, tel que trempe ou bombage. Il est également possible de prévoir sous la couche à base d'oxyde de titane une sous-couche ayant pour effet de favoriser la croissance cristalline de l'oxyde de titane, notamment sous forme anatase. Il peut notamment s'agir d'une sous-couche en ZrO₂, telle que décrite dans la demande WO 02/40417, ou encore une sous-couche favorisant la croissance hétéro-épitaxiale de l'oxyde de titane sous forme anatase, telle que décrite par exemple dans la demande WO 2005/040058, notamment une couche en BaTiO₃ ou SrTiO₃. La couche d'oxyde de titane peut également être la dernière couche d'un empilement bas-émissif et/ou de contrôle solaire. Elle permet dans ce cas de limiter l'apparition de condensation (buée et/ou givre) sur la surface externe du vitrage, en particulier lorsque le substrat est intégré à un double ou triple vitrage, notamment incliné (par exemple en toitures ou véranda). La présence d'une couche bas-émissive en face externe du vitrage permet de limiter les échanges de chaleur avec l'extérieur pendant la nuit, et donc de maintenir une température de surface du verre supérieure au point de rosée. L'apparition de buée ou de givre est donc fortement atténuée voire totalement supprimée.

Lorsque la couche d'oxyde est une couche d'oxyde de zirconium, elle peut être employée pour ses propriétés de résistance à la corrosion et à la rayure.

Une couche à base d'oxyde de tungstène peut être utilisée pour fabriquer des allèges de couleur bleue.

Le substrat obtenu selon l'invention est de préférence incorporé à un vitrage. Le vitrage peut être simple ou multiple (notamment double ou triple), au sens où il peut comprendre plusieurs feuilles de verre ménageant un espace rempli de gaz. Le vitrage peut également être feuilleté et/ou trempé et/ou durci et/ou bombé.

La face du substrat opposée à la face sur laquelle est déposée la couche d'oxyde, ou le cas échéant une face d'un autre substrat du vitrage multiple, peut être revêtue d'une autre couche fonctionnelle ou d'un empilement de couches fonctionnelles. Il peut notamment s'agir d'une couche photocatalytique. Il peut aussi s'agir de couches ou d'empilements à fonction thermique, notamment antisolaires ou bas-émissifs, par exemple des empilements comprenant une couche d'argent protégée par des couches diélectriques. Il peut encore s'agir d'une couche miroir, notamment à base d'argent. Il peut enfin s'agir d'une laque ou d'un émail destiné à opacifier le vitrage pour en faire un panneau de parement de façade appelé allège. L'allège est disposée sur la façade aux côtés des vitrages non opacifiés et permet d'obtenir des façades entièrement vitrées et homogènes du point de vue esthétique.

D'autres couches ou empilements situés sur la face du substrat opposée à la face sur laquelle est déposée la couche d'oxyde peuvent voir leurs propriétés améliorées grâce au traitement thermique selon l'invention. Il peut notamment s'agir de propriétés liées à une meilleure cristallisation de couches fonctionnelles, par exemple de couches d'argent. Il a ainsi été observé, en particulier dans le cas de substrats en verre dont l'épaisseur est au plus de 6 mm, que le traitement thermique d'oxydation selon l'invention pouvait également diminuer l'émissivité et/ou la résistivité d'empilements bas-émissifs contenant au moins une couche d'argent.

Selon un mode de réalisation préféré de l'invention, on dépose donc sur une face du substrat une couche intermédiaire en titane métallique et sur l'autre face dudit substrat un empilement de couches bas-émissif comprenant au moins une couche d'argent, puis l'on traite ladite couche intermédiaire à l'aide d'au moins un rayonnement laser de sorte que l'émissivité ou la résistivité de l'empilement bas-émissif soit réduite d'au moins 3%. Les gains en émissivité ou en résistivité sont d'au moins 3%, voire 5% et même 10%. On peut ainsi à l'aide d'un seul traitement thermique améliorer les propriétés d'émissivité d'un empilement bas-émissif et obtenir une couche photocatalytique. Cela est rendu possible par le fait que le rayonnement laser n'absorbé qu'en partie par la couche intermédiaire et le substrat, de sorte que l'empilement bas-émissif situé sur l'autre face reçoit une partie de l'énergie du rayonnement, qu'il utilise pour améliorer les propriétés de cristallisation de la ou de chaque couche d'argent. Le produit obtenu possède une fonction photocatalytique, autonettoyante sur une face, qui sera donc plutôt orientée vers l'extérieur d'un bâtiment, et une fonction d'isolation thermique sur l'autre face, qui sera donc plutôt orientée vers l'intérieur du bâtiment.

L'invention est illustrée à l'aide des exemples de réalisation non limitatifs qui suivent.

### EXEMPLE 1

Dans cet exemple, on dépose sur un substrat de verre clair de type silico-sodo-calcique une couche intermédiaire de titane métallique de 5 ou 10 nm d'épaisseur.

La couche intermédiaire est déposée par pulvérisation cathodique à l'aide d'une cible en titane, sous un plasma d'argon.

Les échantillons sont traités sous air à l'aide d'un laser en ligne émettant un rayonnement d'une longueur d'onde de 808 nm, en regard duquel le substrat revêtu vient défiler en translation, à des vitesses allant de 3 à 20 mètres par minute.

La mesure de l'activité photocatalytique est effectuée de la façon suivante, par suivi de la dégradation d'acide stéarique :
- découpe d'échantillons de 5x5 cm²,
- nettoyage des échantillons pendant 45 minutes sous irradiation UV et sous balayage d'oxygène,
- mesure du spectre infrarouge par FTIR pour des nombres d'onde compris entre 4000 et 400cm⁻¹, pour constituer un spectre de référence,
- dépôt d'acide stéarique : 60 microlitres d'une solution d'acide stéarique dissout à raison de 10g/L dans de l'éthanol est déposée par spin-coating sur l'échantillon,
- mesure du spectre infrarouge par FTIR, mesure de l'aire des bandes d'élongation des liaisons CH₂-CH₃ entre 3000 et 2700cm⁻¹,
- exposition au rayonnement de type UVA : la puissance reçue par l'échantillon, d'environ 35 W/m² pour simuler l'exposition en extérieur, est contrôlée par une cellule photoélectrique dans la gamme de longueurs d'onde 315-400nm,
- suivi de la photodégradation de la couche d'acide stéarique par mesure de l'aire des bandes d'élongation des liaisons CH₂-CH₃ entre 3000 et 2700cm⁻¹, après des durées d'exposition successives de deux fois 30 minutes puis une heure.
- l'activité photocatalytique est définie par la pente, exprimée en cm⁻¹.min⁻¹, de la droite représentant l'aire des bandes d'élongation des liaisons CH₂-CH₃ entre 3000 et 2700cm⁻¹ en fonction de la durée d'exposition aux UV, pour une durée comprise entre 0 et 30 minutes.

L'activité photocatalytique des couches obtenues est d'environ 4 à 5.10⁻³ cm⁻¹.min⁻¹ pour des vitesses de défilement allant de 4 à 15 mètres par minute. Les valeurs d'activité photocatalytique sont similaires à celles obtenues pour une couche de 10 nm de TiO₂ déposée par pulvérisation cathodique puis recuite par des moyens conventionnels. La couche de titane a donc bien été oxydée et cristallisée en une phase active, notamment la phase anatase.

L'activité photocatalytique diminue pour les plus grandes vitesses de défilement (20 mètres par minute), témoin d'une oxydation imparfaite.

### EXEMPLE 2

Dans cet exemple, on dépose sur un substrat de verre clair de type silico-sodo-calcique une couche intermédiaire de titane métallique de 5 nm d'épaisseur.

La couche intermédiaire est déposée par pulvérisation cathodique à l'aide d'une cible en titane, sous un plasma d'argon.

Le substrat revêtu est traité à l'aide d'une flamme utilisant comme comburant un mélange d'air (1500 L/min) et d'oxygène (163 L/min) et comme combustible du gaz naturel (214 L/min). La distance entre le substrat et le nez du brûleur est de 12 mm.

Un traitement à une vitesse de 3 mètres par minute permet d'obtenir une activité photocatalytique de 5.10⁻³ cm⁻¹.min⁻¹.

### EXEMPLE 3

On dépose sur un substrat de verre clair de type silico-sodo-calcique une couche intermédiaire de zirconium métallique de 5 nm ou 10 nm d'épaisseur selon les essais.

La couche intermédiaire est déposée par pulvérisation cathodique à l'aide d'une cible en zirconium, sous un plasma d'argon.

Les échantillons sont traités sous air à l'aide d'un laser en ligne émettant un rayonnement d'une longueur d'onde de 980 nm, en regard duquel le substrat revêtu vient défiler en translation, à des vitesses de plusieurs mètres par minute.

Le traitement a pour effet d'oxyder la couche de zirconium en oxyde de zirconium, de sorte que la couche devient parfaitement transparente.

### EXEMPLE 4

Les substrats utilisés dans le cas de l'exemple 3 ont également été traités par flammage, de la même manière que dans le cas de l'exemple 2.

La couche de zirconium métallique est ainsi oxydée en oxyde de zirconium, de sorte que la couche devient parfaitement transparente.

### EXEMPLE 5

On dépose sur un substrat de verre clair de type silico-sodo-calcique une couche intermédiaire de nitrure de zirconium métallique de 5 nm ou 10 nm d'épaisseur selon les essais.

Un traitement par flammage identique à celui décrit dans le cas de l'exemple 2 permet d'obtenir une couche d'oxyde de zirconium parfaitement transparente.

## Revendications

1. Procédé d'obtention d'un substrat revêtu sur au moins une partie de sa surface d'au moins une couche d'oxyde d'un métal M dont l'épaisseur physique est inférieure ou égale à 30 nm, ladite couche d'oxyde n'étant pas comprise dans un empilement de couches comprenant au moins une couche d'argent, ledit procédé comprenant les étapes suivantes :
- on dépose par pulvérisation cathodique au moins une couche intermédiaire d'un matériau choisi parmi le métal M, un nitrure du métal M, un carbure du métal M ou un oxyde sous-stoechiométrique en oxygène du métal M, ladite couche intermédiaire n'étant pas déposée au-dessus ou en-dessous d'une couche à base d'oxyde de titane, l'épaisseur physique de ladite couche intermédiaire étant inférieure ou égale à 30 nm,
- on oxyde au moins une partie de la surface de ladite couche intermédiaire à l'aide d'un traitement thermique, pendant lequel ladite couche intermédiaire est en contact direct avec une atmosphère oxydante, notamment avec de l'air, la température dudit substrat pendant ledit traitement thermique ne dépassant pas 150°C.

2. Procédé selon la revendication 1, tel que le substrat est une feuille de verre.

3. Procédé selon l'une des revendications précédentes, tel que le métal M est choisi parmi le titane, l'étain, le zirconium, le zinc, le tungstène, le tantale, le niobium, le molybdène, le chrome, le nickel, le silicium ou l'aluminium.

4. Procédé selon la revendication précédente, tel que la couche intermédiaire est en titane, la couche d'oxyde obtenue après traitement thermique étant une couche d'oxyde de titane photocatalytique.

5. Procédé selon l'une des revendications précédentes, tel que l'épaisseur physique de la ou chaque couche d'oxyde du métal M est inférieure ou égale à 20 nm, notamment 15 nm.

6. Procédé selon l'une des revendications précédentes, tel que la température du substrat pendant le traitement thermique ne dépasse pas 100°C, notamment 50°C.

7. Procédé selon l'une des revendications précédentes, tel que le traitement thermique est réalisé à l'aide d'au moins un rayonnement laser ou à l'aide d'au moins une flamme.

8. Procédé selon la revendication précédente, tel que le rayonnement laser possède une longueur d'onde comprise entre 500 et 2000 nm, notamment entre 530 et 1200 nm.

9. Procédé selon la revendication 7 ou 8, tel que la puissance surfacique du rayonnement laser au niveau de la couche intermédiaire est supérieure ou égale à 20 kW/cm², notamment 30 kW/cm².

10. Procédé selon l'une des revendications 7 à 9, tel que le rayonnement laser est issu d'au moins un faisceau laser formant une ligne qui irradie simultanément toute ou partie de la largeur du substrat.

11. Procédé selon la revendication précédente, dans lequel on met en oeuvre un déplacement relatif entre d'une part le substrat revêtu de la couche et la ou chaque ligne laser, de sorte que la différence entre les vitesses respectives du substrat et du laser soit supérieure ou égale à 4 mètres par minute, notamment 6 mètres par minute.

12. Procédé selon la revendication 4 et l'une des revendications 7 à 11, dans lequel on dépose sur une face du substrat une couche intermédiaire en titane métallique et sur l'autre face dudit substrat un empilement de couches bas-émissif comprenant au moins une couche d'argent, puis l'on traite ladite couche intermédiaire à l'aide d'au moins un rayonnement laser de sorte que l'émissivité ou la résistivité de l'empilement bas-émissif soit réduite d'au moins 3%.

13. Procédé selon l'une des revendications 1 à 9, tel qu'une partie seulement de la surface de la couche intermédiaire est traitée thermiquement afin de réaliser des motifs, à finalité esthétique ou fonctionnelle.

14. Substrat revêtu sur une partie de la surface d'une de ses faces d'une couche d'oxyde d'un métal M dont l'épaisseur physique est inférieure ou égale à 30 nm, et sur une autre partie de la surface de la même face d'une couche d'un matériau choisi parmi ledit métal M, un nitrure dudit métal M ou un carbure dudit métal M, ladite couche d'oxyde n'étant pas comprise dans un empilement de couches comprenant au moins une couche d'argent.

## Patentansprüche

1. Verfahren für den Erhalt eines Substrats, das auf wenigstens einem Teil seiner Oberfläche mit wenigstens einer Schicht aus einem Oxid eines Metalls M überzogen ist, deren physische Dicke weniger als oder gleich 30 nm beträgt, wobei die Oxidschicht nicht in einem Stapel von Schichten, der wenigstens eine Silberschicht umfasst, enthalten ist, wobei das Verfahren die folgenden Schritte umfasst:
- wenigstens eine Zwischenschicht aus einem Material, ausgewählt aus dem Metall M, einem Nitrid des Metalls M, einem Karbid des Metalls M oder einem Sauerstoff-unterstöchiometrischen Oxid des Metalls M, wird mittels Kathodenzerstäubung abgeschieden, wobei die Zwischenschicht nicht oberhalb oder unterhalb einer Schicht auf Titanoxidbasis abgeschieden wird, wobei die physische Dicke der Zwischenschicht weniger als oder gleich 30 nm beträgt,
- wenigstens ein Teil der Oberfläche der Zwischenschicht wird mit Hilfe einer Wärmebehandlung oxidiert, während derer die Zwischenschicht mit einer oxidierenden Atmosphäre, insbesondere mit Luft, in direktem Kontakt ist, wobei die Temperatur des Substrats während der Wärmebehandlung 150 °C nicht übersteigt.

2. Verfahren nach Anspruch 1, welches derart ist, dass das Substrat eine Glasscheibe ist.

3. Verfahren nach einem der vorhergehenden Ansprüche, welches derart ist, dass das Metall M aus Titan, Zinn, Zirkonium, Zink, Wolfram, Tantal, Niob, Molybdän, Chrom, Nickel, Silizium oder Aluminium ausgewählt ist.

4. Verfahren nach dem vorhergehenden Anspruch, welches derart ist, dass die Zwischenschicht aus Titan ist, wobei die nach der Wärmebehandlung erhaltene Oxidschicht eine Schicht aus photokatalytischem Titanoxid ist.

5. Verfahren nach einem der vorhergehenden Ansprüche, welches derart ist, dass die physische Dicke der oder jeder Oxidschicht des Metalls M weniger als oder gleich 20 nm, insbesondere 15 nm beträgt.

6. Verfahren nach einem der vorhergehenden Ansprüche, welches derart ist, dass die Temperatur des Substrats während der Wärmebehandlung 100 °C, insbesondere 50 °C nicht übersteigt.

7. Verfahren nach einem der vorhergehenden Ansprüche, welches derart ist, dass die Wärmebehandlung mit Hilfe wenigstens einer Laserstrahlung oder mit Hilfe wenigstens einer Flamme durchgeführt wird.

8. Verfahren nach dem vorhergehenden Anspruch, welches derart ist, dass die Laserstrahlung eine Wellenlänge im Bereich zwischen 500 und 2000 nm, insbesondere zwischen 530 und 1200 nm besitzt.

9. Verfahren nach Anspruch 7 oder 8, welches derart ist, dass die Leistungsflussdichte der Laserstrahlung im Bereich der Zwischenschicht mehr als oder gleich 20 kW/cm², insbesondere 30 kW/cm² beträgt.

10. Verfahren nach einem der Ansprüche 7 bis 9, welches derart ist, dass die Laserstrahlung aus wenigstens einem Laserstrahl stammt, der eine Linie bildet, welche die gesamte Breite des Substrats oder einen Teil hiervon gleichzeitig bestrahlt.

11. Verfahren nach dem vorhergehenden Anspruch, bei dem eine Relativbewegung zwischen einerseits dem mit der Schicht überzogenen Substrat und der oder jeder Laserlinie eingesetzt wird, so dass der Unterschied zwischen den jeweiligen Geschwindigkeiten des Substrats und des Lasers größer oder gleich 4 Meter pro Minute, insbesondere 6 Meter pro Minute ist.

12. Verfahren nach Anspruch 4 und einem der Ansprüche 7 bis 11, bei dem auf einer Seite des Substrats eine Zwischenschicht aus metallischem Titan und auf der anderen Seite des Substrats ein niedrig emittierender Schichtenstapel, der wenigstens eine Silberschicht umfasst, abgeschieden wird, anschließend die Zwischenschicht mit Hilfe wenigstens einer Laserstrahlung behandelt wird, so dass die Emissivität oder der spezifische Widerstand des niedrig emittierenden Stapels um wenigstens 3 % reduziert ist.

13. Verfahren nach einem der Ansprüche 1 bis 9, welches derart ist, dass nur ein Teil der Oberfläche der Zwischenschicht wärmebehandelt wird, um Muster mit ästhetischem oder funktionellem Zweck auszubilden.

14. Substrat, das auf einem Teil der Oberfläche einer seiner Seiten mit einer Schicht aus einem Oxid eines Metall M überzogen ist, deren physische Dicke weniger als oder gleich 30 nm beträgt, und auf einem anderen Teil der Oberfläche der gleichen Seite mit einer Schicht aus einem Material, ausgewählt aus dem Metall M, einem Nitrid des Metalls M oder einem Karbid des Metalls M, wobei die Oxidschicht nicht in einem Stapel von Schichten, der wenigstens eine Silberschicht umfasst, enthalten ist.

## Claims

1. A process for obtaining a substrate coated on at least part of its surface with at least one film of oxide of a metal M the physical thickness of which is 30 nm or less, said oxide film not being part of a multilayer comprising at least one silver film, said process comprising the following steps:
- at least one intermediate film of a material chosen from the metal M, a nitride of the metal M, a carbide of the metal M and an oxygen-sub-stoichiometric oxide of the metal M is deposited by sputtering, said intermediate film not being deposited above or beneath a titanium-oxide-based film, the physical thickness of said intermediate film being 30 nm or less; and
- at least part of the surface of said intermediate film is oxidized using a heat treatment, during which said intermediate film is in direct contact with an oxidizing atmosphere, especially air, the temperature of said substrate during said heat treatment not exceeding 150°C.

2. The process as claimed in claim 1, such that the substrate is a sheet of glass.

3. The process as claimed in either one of the preceding claims, such that the metal M is chosen from titanium, tin, zirconium, zinc, tungsten, tantalum, niobium, molybdenum, chromium, nickel, silicon and aluminum.

4. The process as claimed in the preceding claim, such that the intermediate film is made of titanium, the oxide film obtained after heat treatment being a photocatalytic titanium oxide film.

5. The process as claimed in one of the preceding claims, such that the physical thickness of the or each film of oxide of the metal M is 20 nm or less, especially 15 nm.

6. The process as claimed in one of the preceding claims, such that the temperature of the substrate during the heat treatment does not exceed 100°C, especially 50°C.

7. The process as claimed in one of the preceding claims, such that the heat treatment is carried out using at least one laser radiation or using at least one flame.

8. The process as claimed in the preceding claim, such that the laser radiation has a wavelength between 500 and 2000 nm, especially between 530 and 1200 nm.

9. The process as claimed in either of claim 7 and 8, such that the power per unit area of the laser radiation at the intermediate film is greater than or equal to 20 kW/cm², especially 30 kW/cm².

10. The process as claimed in one of claims 7 to 9, such that the laser radiation comes from at least one laser beam forming a line that simultaneously irradiates all or part of the width of the substrate.

11. The process as claimed in the preceding claim, in which the substrate coated with the film and the or each line laser are moved relative to one another, so that the difference between the respective speeds of the substrate and the laser is 4 meters per minute or higher, especially 6 meters per minute.

12. The process as claimed in claim 4 and one of claims 7 to 11, in which an intermediate film made of metallic titanium is deposited on one side of the substrate and, on the other side of said substrate, a low-E multilayer comprising at least one silver film is deposited, then said intermediate film is treated using at least one laser radiation so that the emissivity or resistivity of the low-E multilayer is reduced by at least 3%.

13. The process as claimed in one of claims 1 to 9, such that only part of the surface of the intermediate film is heat treated in order to produce patterns, for esthetic or functional purposes.

14. A substrate coated on a part of the area of one of its sides with a film of oxide of a metal M the physical thickness of which is 30 nm or less, and on another part of the area of the same side with a film of a material chosen from said metal M, a nitride of said metal M and a carbide of said metal M, said oxide film not being part of a multilayer comprising at least one silver film.
